(19) Europäisches Patentamt | European Patent Office | Office européen des brevets

(11) **EP 2 306 636 B1**

(12) **EUROPEAN PATENT SPECIFICATION**

(45) Date of publication and mention
of the grant of the patent:
**15.05.2013 Bulletin 2013/20**

(51) Int Cl.:
*H03B 5/12* *(2006.01)*    *H03B 5/18* *(2006.01)*

(21) Application number: **10174140.3**

(22) Date of filing: **26.08.2010**

(54) **Resonant circuit for microwave oscillators**

Schwingkreis für Mikrowellenoszillator

Circuit résonant pour des oscillateurs à micro-ondes

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(30) Priority: **30.09.2009 IT MI20091685**

(43) Date of publication of application:
**06.04.2011 Bulletin 2011/14**

(73) Proprietor: **SIAE Microelettronica S.p.A.
20093 Cologno Monzese (MI) (IT)**

(72) Inventors:
• **Favre, Giulio**
  **20093 Cologno Monzese (IT)**
• **Traversa, Antonio**
  **20093 Cologno Monzese (IT)**

(74) Representative: **Raimondi, Margherita
Dott. Ing. Prof. Alfredo Raimondi S.r.l.,
Piazzale Cadorna, 15
20123 Milano (IT)**

(56) References cited:
**US-A- 4 598 423    US-A1- 2003 090 332**

EP 2 306 636 B1

**Description**

The present invention relates to an improved resonant circuit for reducing the phase noise of a high tuning band microwave oscillator and to an oscillator equipped with said resonant circuit.

It is known in the technical sector of telecommunications that there exists the need for sinusoidal oscillators for microwave radio transmissions and various methods for manufacturing said oscillators are also known.

One of the most widely used methods is based on coupling an LC resonant circuit with an active circuit which operates as a negative-value resistance.

Figure 1 shows the diagram of an example of an oscillator known from JP 60210013 in the field of microwaves and formed by means of an integrated circuit, in which: the inductance is provided by means of a conducting microstrip L which is deposited on a dielectric substrate and the length $\ell$ of which is related to the predefined resonance frequency and the capacitance of which, for formation of the LC resonant circuit, envisages the use of two capacitors C1,C2, at least one of which is variable and consists of a varactor diode which is arranged at the input of the active circuit. Similar arrangements are presented in US 4 598 423 and EP 0 823 777.

The use of two variable capacitors is able to produce an increase in the tuning band amplitude; however, it does not effectively help reduce the phase noise which is the main disturbance responsible for the reduction in the quality of the oscillators, in particular at the high microwave frequencies.

Other examples of the prior art according to the preamble of claim 1 are described in US 2008/0001680 which illustrates a Ladder network circuit which is able to broaden the tuning band and/or provide several different-amplitude outputs, whence the multiple-mesh embodiment, with capacitors arranged in parallel with each other, such that the current which flows in each node is divided up into several fractions and the corresponding circuits L and C are not passed through by the same current, as is required for a circuit in which the components are all arranged in series.

The document therefore does not provide a substantial contribution towards solving the problem of disturbance resulting from phase noise.

This disturbance is due to a number of causes, which are not directly related, such as thermal noise, quantization noise of the device, noise in the substrate of the integrated circuits, power supply noise, which result in unstable timing of the oscillation period (timing jitter), and spectral dispersion.

The consequence of this noise is the introduction of a parasitic amplitude and phase modulation such as to convert a point relating to a modulation state (symbol) into a dispersed cloud of points with a consequent reduction in the noise margin. This phenomenon has particularly damaging effects in modern QAM digital-signal transmission systems in which the increase in the quantity of the levels transmitted gradually reduces the distance between the points of the constellations, decreasing the noise margin and making the system more sensitive to the phase noise with a consequent increase in the probability of connection errors.

The technical problem which is posed, therefore, is to provide a resonant circuit for oscillators used in microwave transceivers, which is able to reduce the phase noise compared to the prior art, so as to adapt the oscillators of the present-day digital radio relays to the ever-increasing need for a greater transmission capacity which requires a consequent improvement in the signal/noise ratio.

In connection with this problem it is also required that the resonant circuit should be able to be manufactured simply and at a low cost.

These results are achieved according to the present invention by a microwave oscillator equipped with a resonant circuit according to the characteristic features of Claim 1.

Further details may be obtained from the following description of a non-limiting example of embodiment of the resonant circuit according to the present invention provided with reference to the accompanying drawings in which:

Figure 1    shows the basic circuit diagram of an embodiment of an oscillator according to the prior art;

Figure 2    shows the basic circuit diagram of an embodiment of an oscillator according to the present invention; and

Figure 3    shows the graph for the "phase noise" depending on the length ratios between the inductive microstrips with curves corresponding to three examples of variation thereof.

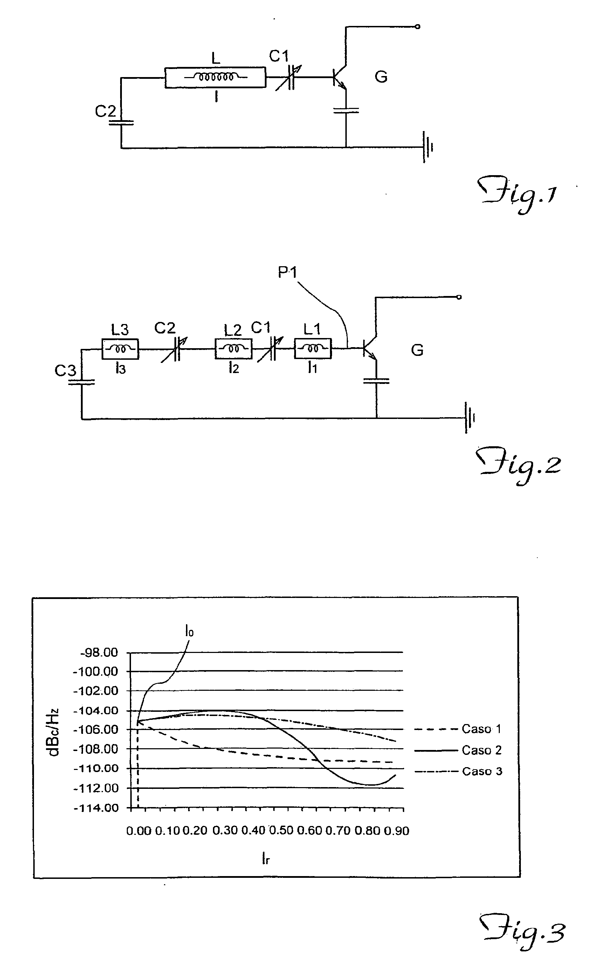

As described in the introductory part, Fig. 1 shows a resonant circuit implemented according to the prior art by means of two capacitors C1,C2, at least one of which is variable and which are separated by a line L which forms the inductive part of the resonant circuit; this structure, although being effective in terms of the requirements for broadening of the useful tuning band, is unable to help improve in any way the phase noise.

Figure 2 shows an example of embodiment of the LC resonant circuit according to the present invention in which it is envisaged that the inductive part L of the circuit is divided into three inductances L1,L2,L3 which are formed by means of corresponding microstrips with a respective length ($\ell_1$, ($\ell_2$, ($\ell_3$, and that the capacitive component C is divided up into a corresponding number of capacitors C1,C2,C3, at least one of which is variable and which are arranged in series along the line so as to alternate with the inductive microstrips.

The capacitances and inductances are designed with dimensions such as to resonate at the predefined operating frequencies of the circuit and the oscillator to which the circuit is connected.

In particular, the first inductance L1 is arranged immediately upstream of the port P1 of a generator G which operates in a known manner as a negative resistance.

The experimental tests carried out with the resonant circuit according to the invention showed that there was a decrease in the phase noise as illustrated in Fig. 3 which is a graph showing, along the y axis, the phase noise/signal ratio dBc/Hz and, along the x axis, the values $\ell_r$ of a ratio $\ell_r = \ell_{var}/(\ell_1 + \ell_2 + \ell_3)$.

in which:

$\ell var =$ length of the microstrip in each case assumed as the reference value for the individual test and

$$\ell_1 + \ell_2 + \ell_3 = \ell tot = \text{COST}$$

In detail:

EXAMPLE 1

Starting with initial values where:

$$\ell_1 = 2000\mu m; \quad \ell_2 = 10 \ \mu m; \quad \ell_3 = 10 \ \mu m,$$

the inductance L3 and therefore the length $\ell_3$ have been kept constant, increasing the value of the inductance L2 and decreasing correspondingly the inductance L1 so as to keep $\ell_1 + \ell_2 + \ell_3$ = COST, and, for the purposes of graphic illustration in the figures, it has been assumed that:

$$\ell_r = \ell_2 / (\ell_1 + \ell_2 + \ell_3);$$

the values of the noise/signal ratio are represented by the broken line curve indicated as Example 1.

EXAMPLE 2

Starting with the same initial values where:

$$\ell_1 = 2000\mu m; \quad \ell_2 = 10 \ \mu m; \quad \ell_3 = 10 \ \mu m,$$

the inductance L3 and therefore the length $\ell_3$ have been kept constant, increasing the value of the inductance L2 and correspondingly decreasing the inductance L1 so as to keep $\ell_1 + \ell_2 + \ell_3$ = COST .

In this case it has been assumed that:

$$\ell_r = \ell_3 / (\ell_1 + \ell_2 + \ell_3);$$

the values of the noise/signal ratio are represented by the continuous-line curve indicated as Example 2, with a very low minimum value.

EXAMPLE 3

Starting with the same initial values where:

$$\ell_1 = 2000\mu m;\ \ \ell_2 = 10\ \mu m;\ \ \ell_3 = 10\ \mu m,$$

both the inductances L3 and L2 have been increased, increasing the associated lengths $\ell_2$ , $\ell_3$, while keeping L2=L3, and correspondingly decreasing the inductance L1 so as to keep $\ell_1 + \ell_2 + \ell_3$ = COST, assuming:

$$\ell_r = (\ell_3 + \ell_2)/(\ell_1 + \ell_2 + \ell_3)\ ;$$

the values of the noise/signal ratio are represented by the dot-dash line curve indicated as Example 3.

As can be seen, all the curves in Fig. 3 show a reduction in the phase noise compared to the prior art represented by the initial value $\ell_0 = \ell_1 + \ell_2 + \ell_3 = \ell$ corresponding to the configuration known from JP 60210013.

According to the invention it is also envisaged that the resonant circuit is formed with a monolithic integrated structure (MMIC) and that in a preferred embodiment the inductive microstrip has a central conductor with several conductive layers separated by a dielectric and connected at the opposite ends only in accordance with that envisaged by a co-pending patent application in the name of the same present applicant.

It is therefore clear how, with the resonant circuit according to the present invention, it is possible to obtain, in a simple and low cost manner, oscillators able to provide particularly low phase-noise values within a wide tuning band, this effect being particularly useful at the high microwave frequencies of between 4 and 20 GHz and for the purposes of the increasingly more advanced QAM requirements of digital transmission technology.

Although described in connection with a preferred embodiment of the invention, it is understood that the scope of protection of the present patent is defined solely by the following claims.

**Claims**

1. Microwave oscillator comprising an active bipolar circuit (G) having an input (P1) and showing a negative resistance to a resonant circuit (LC) interposed between the input (P1) of the former and ground, said resonant circuit (LC) comprising a capacitive part (C) divided into a number of capacitors (C1,C2,C3) and an inductive part (L) **<u>charac-terized in that</u>** said capacitive part comprises at least three capacitors (C1,C2,C3), at least one of which is variable and said inductive part is divided into three inductive elements (L1,L2,L3), a first (L1) of which (L1,L2,L3) is interposed in series between the input (P1) of the active circuit (G) of the oscillator and a first capacitor (C1), a second inductive element (L2) is interposed in series between said first capacitor (C1) and a second capacitor (C2) and a third inductive element (L3) is interposed in series between said second capacitor (C2) and a third capacitor (C3) and **in that** the sum of the three inductances (L1,L2,L3) is constant and equal to a the value (L) of the resonance inductance resonating with the number of capacitors (C1,C2,C3) arranged in series to the inductances at the fundamental frequency of the oscillator (G).

2. Microwave oscillator according to Claim 1, **characterized in that** it is formed with a monolithic integrated structure.

3. Microwave oscillator according to Claim 1, **characterized in that** the inductances (L1,L2,L3) are formed as a microstrip with a respective length $\ell1$, $\ell2$, $\ell3$ such that $\ell1+\ell2+\ell3=\ell.$=COST

4. Microwave oscillator according to Claim 1 **characterized in that** the oscillation output frequency ranges between 4 and 20 GHz.

**Patentansprüche**

1. Mikrowellenoszillator, eine aktive bipolare Schaltung (G) umfassend, die einen Eingang (P1) aufweist und gegenüber einer Resonanzschaltung (LC), welche zwischen dem Eingang (P1) der ersteren und Masse angeordnet ist, einen negativen Widerstand zeigt, wobei die Resonanzschaltung (LC) einen kapazitiven Teil (C), der in eine Anzahl von Kondensatoren (C1, C2, C3) aufgeteilt ist, und einen induktiven Teil (L) aufweist, **dadurch gekennzeichnet, dass** der kapazitive Teil mindestens drei Kondensatoren (C1, C2, C3) aufweist, von denen mindestens einer variabel ist, und der induktive Teil in drei induktive Elemente (L1, L2, L3) aufgeteilt ist, wobei einer erstes (L1) von diesen (L1, L2, L3) in Reihe zwischen dem Eingang (P1) der aktiven Schaltung (G) des Oszillators und einem zweiten Kondensator (C1) angeordnet ist, ein zweites induktives Element (L2) in Reihe zwischen dem ersten Kondensator (C1) und einem zweiten Kondensator (C2) angeordnet ist, und ein drittes induktive Element (L3) in Reihe zwischen dem zweiten Kondensator (C2) und einem dritten Kondensator (C3) angeordnet ist, und dadurch, dass die Summe der drei Induktivitäten (L1, L2, L3) konstant ist und einem Wert (L) der Resonanzinduktivität, die mit der Anzahl von Kondensatoren (C1, C2, C3), die mit den Induktivitäten in Reihe angeordnet sind, bei der fundamentalen Frequenz des Oszillators (G) mitschwingen, gleich ist.

2. Mikrowellenoszillator nach Anspruch 1, **dadurch gekennzeichnet, dass** er mit einer monolithischen integrierten Struktur ausgebildet ist.

3. Mikrowellenoszillator nach Anspruch 1, **dadurch gekennzeichnet, dass** die Induktivitäten (L1, L2, L3) als Streifenleitungen mit einer jeweiligen Länge 11, 12, 13 ausgebildet sind, so dass 11+12+13 =1= COST

4. Mikrowellenoszillator nach Anspruch 1, **dadurch gekennzeichnet, dass** die Oszillationsausgangsfrequenz im Bereich zwischen 4 und 20 GHz liegt.


**Revendications**

1. Oscillateur micro-onde comprenant un circuit actif bipolaire (G) comportant une entrée (P1) et présentant une résistance négative à un circuit résonant (LC) interposé entre l'entrée (P1) du premier et une masse, ledit circuit résonant (LC) comprenant une partie capacitive (C) divisée en un nombre de condensateurs (C1, C2, C3) et une partie inductive (L) **caractérisé en ce que** ladite partie capacitive comprend au moins trois condensateurs (C1, C2, C3) dont au moins un est variable et **en ce que** ladite partie inductive est divisée en trois éléments inductifs (L1, L2, L3), un premier élément (L1) desdits éléments (L1, L2, L3) étant interposé en série entre l'entrée (P1) du réseau actif (G) de l'oscillateur et un premier condensateur (C1), un deuxième élément inductif (L2) étant interposé en série entre ledit premier condensateur (C1) et un deuxième condensateur (C2) et un troisième élément inductif (L3) étant interposé en série entre ledit deuxième condensateur (C2) et un troisième condensateur (C3) et **en ce que** la somme des trois inductances (L1, L2, L3) est constante et égale à la valeur (L) de l'inductance de résonance résonant avec le nombre de condensateurs (C1, C2, C3) agencés en série avec les inductances à la fréquence fondamentale de l'oscillateur (G).

2. Oscillateur micro-onde selon la revendication 1, **caractérisé en ce que** celui-ci est formé avec une structure intégrée monolithique.

3. Oscillateur micro-onde selon la revendication 1, **caractérisé en ce que** les inductances (L1, L2, L3) sont formées comme un microruban ayant une longueur respective $\ell$i, $\ell$2 $\ell$3 de sorte que $\ell$1 + $\ell$2 + $\ell$3 = $\ell$. = COST

4. Oscillateur micro-onde selon la revendication 1, **caractérisé en ce que** la fréquence de sortie d'oscillation est située entre 4 et 20 GHz.

Fig.1

Fig.2

Fig.3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 60210013 B
- US 4598423 A
- EP 0823777 A
- US 20080001680 A